# EUROPEAN PATENT SPECIFICATION

(11) **EP 2 167 269 B1**
(45) Date of publication and mention of the grant of the patent: **08.06.2011**
(21) Application number: 07794234.0
(22) Date of filing: 24.07.2007
(51) Int. Cl.: B23K 20/00, B23K 20/10

(54) **WIRE BONDING CAPILLARY TOOL HAVING MULTIPLE OUTER STEPS**
DRAHTVERBINDUNGS-KAPILLARWERKZEUG MIT MEHREREN ÄUSSEREN ABSÄTZEN
OUTIL CAPILLAIRE DE SOUDURE DE FILS AYANT DE MULTIPLES GRADUATIONS EXTERNES

(43) Date of publication of application: 31.03.2010
(73) Proprietor: Small Precision Tools INC., Petaluma, California 94954 (US)
(72) Inventor: CASTANEDA, Jaime, Singapore 556133 (SG); GOH, Kay Soon, Singapore 320013 (SG)
(74) Representative: Viering, Jentschura & Partner
(86) International application number: PCT/SG2007/000220
(87) International publication number: WO 2009/014494

(56) References cited:
- GB-A- 2 285 943
- US-A- 5 503 321
- US-A- 5 884 835
- US-A1- 2002 033 408
- US-A1- 2003 146 267
- US-A1- 2004 188 499
- US-A1- 2005 252 950
- US-A1- 2005 275 073

## Description

### TECHNICAL FIELD

The present invention relates to the field of wire bonding capillary tools for bonding a fine wire to a substrate, and more specifically, to a wire bonding capillary tool having a high impedance values and being optimized for ultrasonic energy transfer compliancy.

### BACKGROUND

Printed circuit boards (PCB) are commonly used in the manufacture of digital devices, automated testing equipment (ATE) and in a range of general electronic equipment. Each PCB has a variety of electronic components mounted thereon. Examples of such components include semiconductor chips, integrated circuits (IC), resistors, transistors and capacitors. The electrical connection between each mounted component and the PCB (which may also be referred to as a substrate), is commonly taken to be part of the semi-conductor packaging process and is of paramount importance. An improper or faulty electrical connection between the electrical component and the PCB is likely to result in the functional failure of the device or equipment in which the faulty connection occurs.

Amongst the above-mentioned components that are commonly mounted onto a PCB, the IC may be considered to be one of the most important. In mounting the IC onto the PCB, manufacturers have typically relied on three techniques, namely, wire bonding, tape automated bonding (TAB) and flip-chip mounting technology. Amongst the three techniques of mounting an IC, wire bonding is the most commonly used method. In wire bonding, the PCB (or substrate) has a plurality of bonding pads situated thereon in a predetermined pattern. The IC, having electrical leads, is typically mounted in the center of the predetermined pattern of bonding pads and its electrical leads are then connected to the bonding pads. The electrical connections between the IC and the PCB are established by using either copper, gold or aluminum wires having diameters typically between the range of about 10 - about 200 microns, depending upon the requirements of the circuit and bond pad size. The wires are usually attached with one end to the electrical lead of the mounted IC, then drawn towards the respective bonding pad, and are finally attached to the appropriate bonding pad thereby establishing an electrical connection between the substrate and the IC mounted thereon.

The establishment of the electrical connection between the mounted IC and its respective substrate, as described above, is carried out by a bonding tool. The bonding tool supplies the fine wire and employs a method known as ball bonding to electrically connect the electrical leads of the IC to the bond pads of the substrate. The bonding tool comprises a capillary through which the fine wire is threaded through. The capillaries are typically made from a ceramic material such as aluminum oxide, tungsten carbide and aluminum toughened zircon, for example. An example of such a conventional wire bonding tool is described in U.S. Patent 6,910,612. This U.S. Patent describes a bonding tool having a cylindrical axial passage coupled to a working tip having an inner annular chamfer. The annular chamfer has a predetermined angle and face length, which essentially go towards shaping the ball bond during the bonding process.

The process of wire bonding involves having the wire threaded through the capillary and leaving a free end of the wire at the working tip of the capillary. The free end of the wire at the working tip of the capillary is the end that forms the ball for ball bonding, which is a form of wire bonding. As an exemplary illustration, when a gold fine wire is used, the process is known as gold ball bonding. During gold bond bonding, a gold ball is first formed by melting the end of the wire at the capillary tip through electronic flame-off (EFO). This gold ball, which is generically known as a free-air ball, typically has a diameter ranging from 1.5 to 2.5 times that of the wire diameter. The free-air ball size consistency is controlled by the EFO. The free-air ball is then brought into contact with the bond pad of the substrate or the electrical lead of the mounted IC. When the free-air ball contacts the bond pad, for example, adequate amounts of pressure, heat, and ultrasonic forces are then applied to the ball bond for a specific amount of time, thus forming the initial metallurgical weld between the ball and the bond pad, as well as deforming the ball bond itself into its final shape. The wire is then run to the electrical lead corresponding to the bond pad to create a gradual arc or "loop" between the bond pad and the electrical lead. Pressure and ultrasonic forces are applied to the wire to form the second bond (known as a wedge bond, or stitch bond) with the electrical lead in order to complete one bonding cycle.

With regard to the application of ultrasonic energy, the effect of such energy causes the bonding tool, in particular, the tip of the capillary, to oscillate. Accordingly, when ultrasonic energy is applied to the bonding tool after the ball bond is formed, the bonding tool, in effect, scrubs the ball bond against the bond pad. This scrubbing action cleans the bond pad, which is typically aluminum, of debris and oxides, such as aluminum oxide, for example. This scrubbing action exposes a fresh surface of the bond pad in the process. The metallurgical bond or weld between the ball bond and the bond pad is further enhanced with the continued application of ultrasonic energy, resulting in plastic deformation of the ball bond and bond pad against each other. Aside from the physical contact and deformation of the metals unto each other, inter-diffusion of the ball bond and bond pad metal atoms also occurs, which further enhances the metallurgical bond. In general, bond reliability increases with the level of inter-diffusion that takes place. The most common reason for insufficient inter-diffusion is the presence of foreign materials or contaminants on the surface of the bond pad, such as oxides, unetched glass, silicon saw dust, and process residues, for example. The importance of the application of sufficient ultrasonic energy to achieve a reliable bond is underscored by the need to also ensure that the bond pad is free of contaminants.

Presently, there is a growing trend in the semiconductor industry to use materials having sensitive metallization such as materials with low dielectric constants (low K value), for example. Materials having a sensitive metallization also include ultra-thin bond pads. Generally, materials with such sensitive metallization have poor mechanical properties, low thermal conductivity and are more susceptible to metal peel-off, cratering and oxide cracks during wire bonding.

Another growing trend in the industry is the carrying out of 'bonding over active circuitry'. This requires a stable wire bonding process especially since 'bonding over active circuitry' essentially involves forming a metal bond pad with a metal layer thereon over circuitry in the semiconductor chip.

Bonding tools, where the amount of combined mechanical stress from the applied ultrasonic energy, impedance and the impact force of said bonding tool on the bond pad may result in serious damage occurring to the bond pads with sensitive metallization. Furthermore, such conventional bonding tools may not be able to form bonds reliable enough for carrying out 'bonding over active circuitry'.

Typically, when a conventional bonding tool, such as that described in the aforesaid U.S. Patent 6,910,612, is used in conjunction with a substrate of a low K value, the ultrasonic energy delivered at the working tip of conventional bonding tools is usually insufficient to bond low K bond pads through metallization. The working tip of the conventional capillary requires higher power ultrasonic settings to bond sufficiently with a bond pad of low K value. However, if a higher ultrasonic energy is supplied, it tends to further aggravate the above-mentioned problems of metal peel-off, cratering and oxide cracks.

In response to the above-mentioned problem concerning materials having a low-K value, U.S Patent 6,321,969 discloses a wire bonding tool that is capable of a more efficient transfer of ultrasonic energy from the ultrasonic source to the working tip of the tool. As mentioned above, apart from scrubbing oxide of a bond pad, the oscillating action of the working tip, when ultrasonic energy is applied to it, aids in the inter-diffusion of the bond and bond pad metal atoms thereby further enhancing the metallurgical bond. Accordingly, U.S. Patent 6,321,969 discloses that if a more efficient transfer of ultrasonic energy to the working tip takes place, a lower amount of said ultrasonic energy may then be applied to oscillate the working tip, thereby avoiding the aforesaid difficulties associated with bonding materials having a low-K value.
Document US-A1-2002/0033408 discloses a bonding tool for bonding a fine wire to a substrate, wherein the bonding tool (300) comprises an upper cylindrical body portion (302), a lower cylindrical body portion (304), and a conical body portion (306) (see, for example, Figs. 3A-3D, & para. [0045]). However, US-A1-2002/0033408 does not disclose the feature of "a plurality of at least two discrete intervals along the length of the cylindrical portion" as recited in claim 1. It should be noted that US-A1-2002/0033408 only discloses one discrete interval in the cylindrical body portion, namely the transition area 312 between the upper cylindrical body portion 302 and the lower cylindrical body portion 304. It should also be noted that the conical body portion 306 in US-A1-2002/0033408 does not belong to cylindrical body portion. This is because the definition of "cylindrical" and "conical" is completely different.

However, there is still a need for a wire bonding tool capillary that is capable of forming reliable wire bonds with substrates having sensitive metallization, and for carrying out 'bonding over active circuitry'. There is also a concurrent need for the bonding tool to be easily integrated into existing wire bonding facilities and to be cost-effective as well. In this respect, the wire bonding tool as described in detail hereafter overcomes the aforesaid difficulties.

### SUMMARY

Therefore, in one aspect, the present invention provides a bonding tool for bonding a fine wire to a substrate. This bonding tool comprises an at least substantially cylindrical portion having a concentric capillary therein through which the fine wire runs; a working tip portion formed at an end of the cylindrical portion being tapered towards the tip thereof. The working tip portion having an annular chamfer at the tip thereof; wherein the concentric capillary opens into the annular chamfer of the working tip; and wherein the diameter of the cylindrical portion decreases consecutively at a plurality of at least two discrete intervals along the length of the cylindrical portion towards the working tip portion.

These and other features of the invention will be better understood in light of the following drawings and detailed description.

### BRIEF DESCRIPTION OF THE DRAWINGS

**Figure 1** shows a conventional wire bonding tool;

**Figure 2** shows a first embodiment of the bonding tool;

**Figure 3** shows a second embodiment of the bonding tool;

**Figure 4** shows a third embodiment of the bonding tool;

Figure 5 shows a fourth embodiment of the bonding tool;

**Figures 6A -** 6F show various embodiments of a diametric decrease at a discrete interval;

**Figure 7** shows a graph that illustrates the relationship between the input power to a transducer impedance generated therefrom;

**Figure 8** shows a comparative bar chart between the impedance generated by various bonding tools;

**Figure 9** shows a bar chart comparing the displacement of the conventional bonding tool of **Figure 1** against bonding tools **(****Figures 2****,** **3****, and** **4****)** having a plurality of discrete intervals;

**Figure 10** shows a comparison table for the amplitude displacement ratio of a conventional bonding tool against bonding tools **(****Figures 2****,** **3****,** and 4) having a plurality of discrete intervals;

**Figure 11A** shows the cross-sectional view of a ball bond as produced by a conventional bonding tool;

**Figure 11B** shows the cross-sectional view of a ball bond as produced by a bonding tool having two discrete intervals;

### DETAILED DESCRIPTION

In one aspect, the bonding tool includes an at least substantially cylindrical portion having a concentric capillary therein through which the fine wire runs. A working tip portion is formed at an end of the cylindrical portion, and is tapered towards its tip. The working tip portion also includes an annular chamfer at the tip thereof where one end of the chamfer opens out to the surroundings and its other end is connected to the concentric capillary, such that said capillary opens into the other end of the annular chamfer within the working tip. The diameter of the cylindrical portion decreases consecutively at a plurality of at least two discrete intervals along the length of the cylindrical portion towards the working tip portion.

Generally, it may be taken that there is no fixed upper limit for the number of discrete intervals that may be present along the length of the bonding tool. In one illustrative embodiment, the diameter of the cylindrical portion decreases consecutively at two discrete intervals. In alternative embodiments, the diameter of the cylindrical portion may decrease consecutively at three, four or five discrete intervals. As there is no upper limit, it may also be possible to have as many discrete intervals as one wishes to have. As such, ten, twenty-five, fifty or even one hundred discrete intervals may be present, provided the length of the bonding tool supports that many discrete intervals.

Typically, the consecutive diametric decrease at each of the plurality of discrete intervals is carried out by way of a step, a tapering, or any combination thereof. The step, tapering or otherwise, is generally directed towards the longitudinal central axis of rotation of the cylindrical portion. This results in a reduction in diameter at each discrete interval of the substantially cylindrical portion over the length of the bonding tool, in the direction of the working tip.

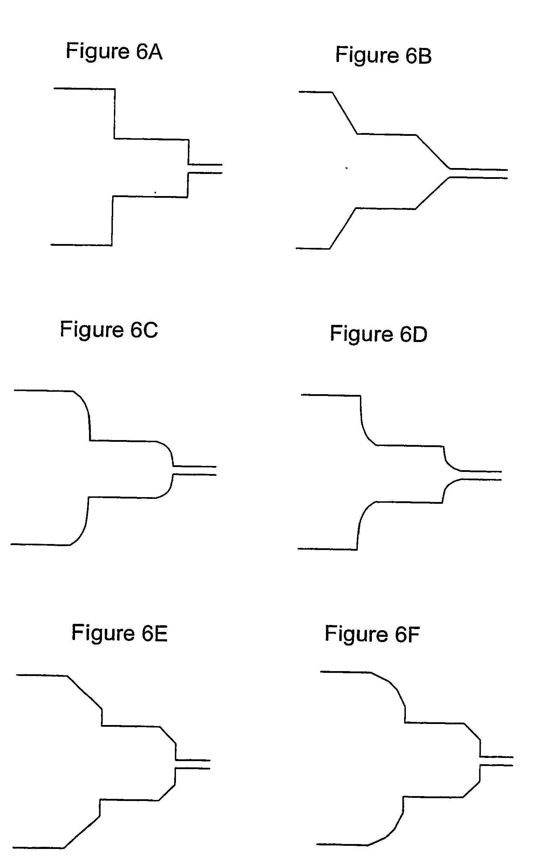

In one embodiment of the invention, the step may essentially be a ninety degree step. In an alternative embodiment, the step is formed out of a plurality of tapers. Each of the plurality of tapers typically occurs towards the central axis. A further alternative embodiment is one where the step is formed in the shape of an arc subtending from a point before the discrete interval (larger diameter) to a point on or after the discrete interval (smaller diameter). The arc may either be concave or convex. Where the diametric reduction is by way of a tapering, the tapering angle may be, but is not limited to, up to about 10 degrees towards the longitudinal central axis of rotation of the cylindrical portion. Variations in the diametric reduction are described in greater detail later in this application with references being made to accompanying **Figures 6A - 6F****.**

Generally, each successive diametric decrease at each of the plurality of discrete intervals is either substantially of absolutely concentric to each other. The plurality of discrete intervals may either be proportionately or equally distributed over the length of the substantially cylindrical portion provided the overall length of the bonding tool is sufficient to accommodate the number of discrete intervals to be included. The typical length of the bonding tool is, but is not limited to, about 11.10mm and in certain cases, may vary anywhere between about 9.0mm to about 20.0mm in length. The length of the concentric capillary therein and annular chamfer is also between about 9.00mm to about 20.00mm. Typically, the concentric capillary may have a diameter less than or equal to about 5.0mm but greater than or equal to about 80.0 µm.

In a first exemplary embodiment of the invention having two discrete intervals, the first and second discrete intervals along the length of the cylindrical portion are distant from the working tip by about 7.10mm and by about 2.65mm, respectively. In this context, the convention for describing the various discrete intervals, which is adhered to throughout the rest of this specification, assumes that the first discrete interval is that which is farthest from the working tip, and the last discrete interval is that which is nearest to the working tip.

Accordingly, in the first embodiment, a diametric decrease takes place at a distance of about 7.10mm and about 2.65mm. Since the diametric decreases takes place consecutively in the direction of the working tip, the diameter prior to the first discrete interval, D1 (about 1.587mm), is greater than the diameter, D2 (about 1.20mm) thereafter. Accordingly, it follows that the diameter, D2, prior to the second discrete interval is about 1.20mm and the diameter, D3, thereafter is about 0.82mm. Therefore, in this embodiment, the diameter decreases in fixed amounts at each discrete interval. That is, at the first discrete interval, the diameter decreases from about 1.587mm to about 1.20mm and subsequently, at the second discrete interval, from about 1.20mm to about 0.82mm. Two discrete intervals create three distinct diameters over the length of the bonding tool of the first exemplary embodiment.

In a second exemplary embodiment where the bonding tool has three discrete intervals, said three discrete intervals are at about 2.65mm, at about 5.375mm and at about 8.10mm from the working tip. The diameter of the substantially cylindrical portion is greatest at a distance of about 8.10mm from the working tip and decreases at each subsequent discrete interval towards the working tip. In this embodiment, the diameter is also initially at about 1.587mm (i.e. just prior to the first discrete interval at about 8.10mm from the working tip). After the first, second and third discrete intervals, the corresponding diameters are about 1.331mm, about 1.076mm and about 0.82mm, respectively. In this embodiment, three discrete intervals create four distinct diameters over the length of the bonding tool of the second exemplary embodiment.

In a third exemplary embodiment where the bonding tool has four discrete intervals, the four discrete intervals are at about 2.65mm, about 4.466mm, about 6.282mm and about 8.098mm from the working tip. The diameter of the substantially cylindrical portion is greatest at a distance of about 8.098mm from the working tip and decreases at each subsequent discrete interval towards the working tip. In this embodiment, the diameter is also initially at about 1.587mm (i.e. just prior to the first discrete interval at about 8.098mm from the working tip). After the first, second, third and fourth discrete intervals, the corresponding diameters are about 1.395mm, about 1.2035mm, about 1.0118mm and about 0.82mm, respectively. In this embodiment, four discrete intervals create five distinct diameters over the length of the bonding tool of the second exemplary embodiment.

As mentioned earlier, the number of discrete intervals along the length of the substantially cylindrical portion may be more than four, i.e. five, six, and seven or even higher numbers of discrete intervals at which a diametric reduction may take place. As a general guideline, the more discrete intervals present, the longer the length of the bonding tool (or substantially circular portion) may have to be. Another general guideline is that if 'n' numbers of discrete intervals are present, then the bonding tool has (n+1) number of different diameters along the length of the bonding tool towards the working tip. Accordingly, the number of diametric reductions up to say about 0.82mm (which is the lower limit of the diameter of the capillary within the substantially circular portion according to the agreed industrial standard, but it is not limited as such by any technical requirement of the bonding tool) may be predetermined and the required number of discrete intervals calculated based on the aforesaid relationship.

With the reduction in diameter, the latitudinal cross-sectional area of the bonding tool decreases as well. The latitudinal cross-sectional shape of the bonding tool may be polygonal, circular or elliptical. Where the latitudinal cross-sectional shape of the bonding tool is polygonal, the cross-sectional shape may be, but is not limited to being, pentagonal in shape, hexagonal in shape or octagonal in shape, for example.

When in operation, the bonding tool is typically attached (or clamped) to a nano-scale ultrasonic energy transducer. The transducer typically clamps up to about 3.0mm of the length of the bonding tool. When activated, the transducer transmits ultrasonic energy to the bonding tool. In this respect, the at least substantially cylindrical portion and working tip are adapted so as to be able to undergo an ultrasonic displacement when ultrasonic energy is transmitted to the bonding tool.

During operation, the ratio of the displacement of the working tip portion to the displacement of the transducer is known as the displacement amplification ratio. The working tip of the bonding tool according to the present invention is generally adapted to have a displacement amplitude ratio of at least about three when undergoing ultrasonic displacement. The ultrasonic displacement of the entire bonding tool, including the at least substantially cylindrical portion and working tip, is at least substantially sinusoidal in shape. The sinusoidal shape has its points of 'approximate zero' displacement typically at the same points where the discrete intervals are located. The points at which approximately zero displacement occurs are also referred to as node points.

The effects of the above-mentioned substantially sinusoidal displacement are demonstrated during the actual bonding process. During said bonding process, the bonding tool and the bond pad contact each other with the bonding tool applying a static compressive force to the bond pad causing static pre-deformation thereof. An ultrasonic generator then introduces a signal to a piezoelectric element. The element drives the transducer at a resonant frequency to maximize the displacement motion. The vibrations are amplified and transmitted to the bonding tool, which is attached perpendicular to the axis of the transducer. The vibrating bonding tool applies oscillatory forces parallel to the bond pad surface. This results in a scrubbing motion between the capillary tip and the bond pad and accounts for the ultrasonic deformation of the bond pad.

Simultaneously, the fine wire within the capillary softens upon absorption of the ultrasonic energy and flows under the load breaking up the surface oxides on the bond pad and exposing a fresh surface of the bond pad. The ultrasonic energy also supplies the activation energy required for inter-diffusion between the metal of the bond pad and that of the ball bond during bond formation. The use of ultrasonic energy during the bond formation therefore enhances the diffusion phenomena.

The bonding tool of the present invention may be fabricated from, but is not limited to, metals, ceramics, or ceramic - metal (CerMet) composites, for example. CerMet is a composite material composed of ceramic (cer) and metallic (met) materials). The metal is used as a binder for an oxide, boride, carbide, or alumina. Generally, the metallic elements used are nickel, titanium molybdenum, and cobalt. Examples of ceramics include, but are not limited to, oxides such as alumina, zirconia, or a mixture of both. Further examples of ceramics also include, but are not limited to, non-oxides such as carbides, nitrides and borides. Some specific examples of non-oxide ceramic materials include, but are not limited to, silicium carbide, silicium nitride and silicon carbide. Examples of CerMet composites include, but are not limited to, cobalt bonded tungsten carbide, titanium carbonitride and titanium nitride.

In a particular embodiment of the bonding tool according to the present invention, said bonding tool includes an at least substantially cylindrical portion having a concentric capillary therein through which the fine wire runs. At an end of the at least substantially cylindrical portion, a working tip portion is formed, said working tip portion being tapered towards its tip. The working tip portion has an annular chamfer at the tip thereof with one end of the annular chamfer opening to the environment. The concentric capillary opens into the other end of the annular chamfer of the working tip. In this preferred embodiment, the diameter of the cylindrical portion decreases consecutively at a first and second discrete interval along the length of the cylindrical portion towards the working tip portion. Each discrete interval may include a step, a tapering and any one combination thereof towards the longitudinal central axis of rotation of the cylindrical portion.

In this particular embodiment, the first and second discrete intervals are distanced at about 7.10mm and about 2.65mm from the working tip, respectively. At the first and second discrete intervals the corresponding decrease in diameter is from about 1.587mm to about 1.20mm and from about 1.20mm to about 0.82mm, respectively. Accordingly, and as mentioned earlier, having two discrete intervals gives rise to three different diameters at various points along the length of the bonding tool.

The bonding tool of the present invention may also be utilized in a wire bonding device that forms a metallurgical bond between a fine wire and a bonding substrate. The bonding device includes a bonding tool for bonding a fine wire to a substrate and a nano-scale ultrasonic energy source connected to said bonding tool such that said source is capable of transmitting ultrasonic energy to the bonding tool. Essentially, the bonding tool utilized may be according to any one of the above-mentioned embodiments. In this embodiment of the bonding device, the bonding may be a bond pad or a leadframe, for example.

### DETAILED DESCRIPTION OF EXEMPLARY EMBODIMENTS

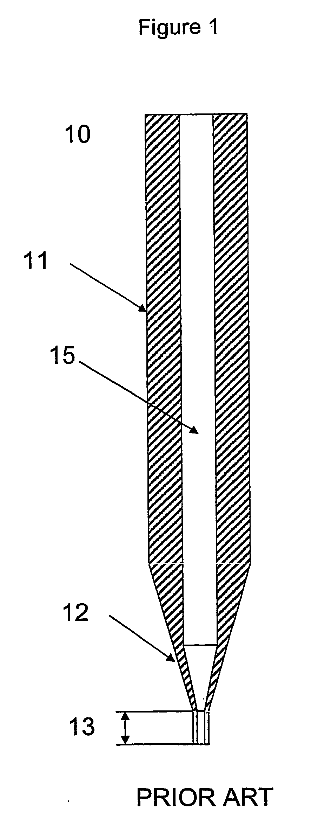

**Figure 1** illustrates a conventional bonding tool capillary **10** of the prior art. The bonding tool **10** has a cylindrical portion **11,** and a tapered working tip portion **12** coupled to the cylindrical portion **11.** At the end of the working tip portion **12,** working tip **13** is formed. Working tip **13** typically has a chamfer (not shown) which has one end in connection to the capillary **15** and its other end that opens to the environment.

The bonding tool **100** is deficient use in bonding materials having a low-K value due to the susceptibility of said materials to metal lifting, cratering, and metal peel off. The ultrasonic energy delivered at the working tip **13** of conventional bonding tools is insufficient and not optimized to allow for the bonding of low-K bond pads and metallization thereof. The working tip **13** of the conventional capillary **100** requires ultrasonic energy at a higher power than what is typically required. However, using ultrasonic energy at higher than normal levels further aggravates the metal lifting, cratering, and metal peel off problems. Furthermore, the conventional capillary bonding tool **100** cannot provide, at such ultrasonic energy levels, a high level of reliable intermetallic coverage between a deformed ball bond, and a bonding pad. This lack of intermetallic coverage causes excessive aluminum extrusion between the ball bond formed on the bond pad metallization.

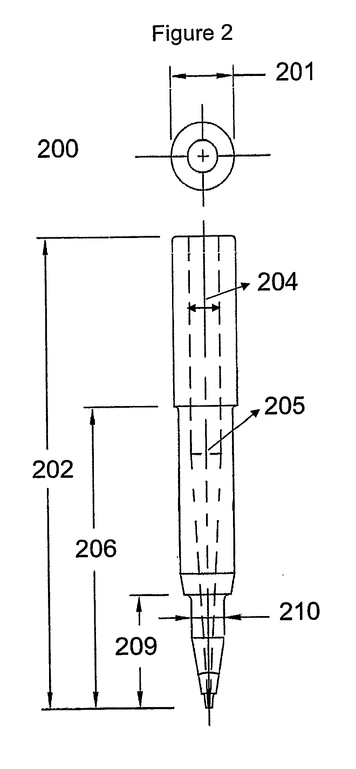

**Figure 2** is the side view of a first embodiment **200** of the invention having two discrete intervals at which a reduction in diameter takes place. As shown in **Figure 2****,** the bonding tool **200** has a two steps defined by vertical relief **206,** and **209.** The distances of vertical relief **206** and vertical relief **209** from the working tip are 7.10mm and 265mm, respectively. The corresponding outer diameters defined at **201, 207,** and **210** are 1.587mm, 1.20mm and 0.82mm, respectively.

The entire length **202** of the capillary is about 11.10mm. However, as the bonding tool is clamped into an ultrasonic source, only the length **202** is capable of having discrete intervals defined thereon. The capillary **204** tapers at an angle 205 towards the working tip portion **209.** In one embodiment, the bonding tool 200 is formed from a unitary piece of material.

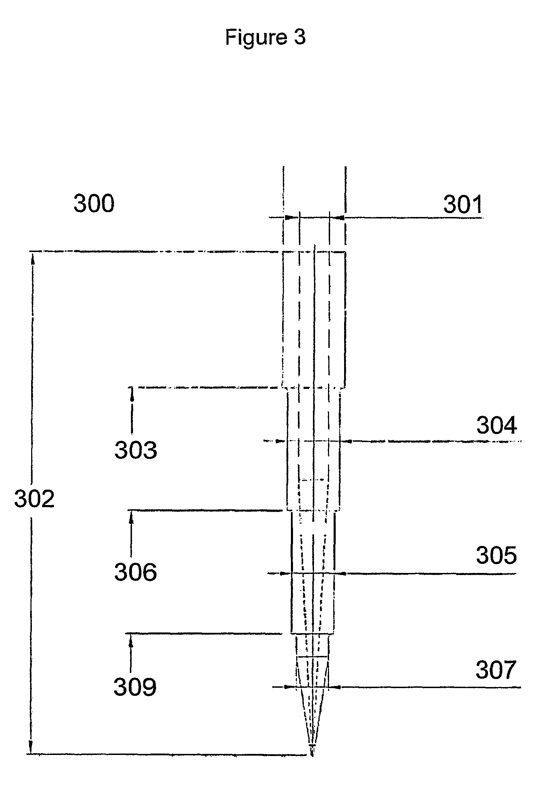

**Figure 3** shows a second embodiment of the bonding tool **300** according to the present invention having three discrete intervals **303, 306, 309** along the entire length of the capillary **302.** The diameter of the bonding tool **300** is initially 1.587mm at **301.** After the first discrete interval at **303,** the diameter of the bonding tool **300** decreases to 1.331 mm at **304.** Subsequently, after the second discrete interval at **306,** the diameter of the bonding tool **300** decreases to 1.076mm at **305.** Finally, after the third discrete interval **309,** the diameter decreases again to 0.82mm at **307.**

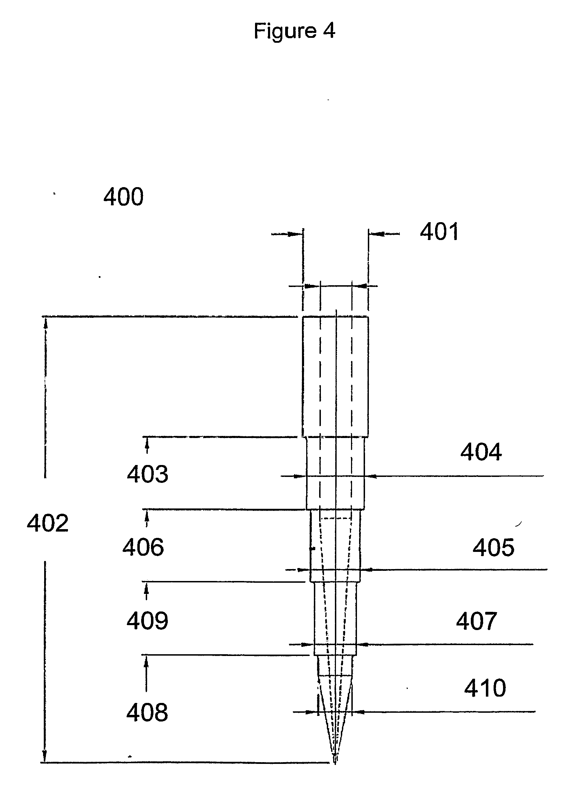

**Figure 4** shows a third embodiment **400** of the bonding tool according to the present invention. The bonding tool **400** has four discrete intervals **403, 406, 408** and **409** along the entire length of the capillary **402.** The diameter of the bonding tool **400** is initially at about 1.587mm at **401.** After the first discrete interval at **403,** the diameter of the bonding tool **400** decreases to about 1.395mm at **404.** Subsequently, after the second discrete interval at **406,** the diameter of the bonding tool **400** decreases to about 1.2035mm at **405.** After the third discrete interval **409,** the diameter decreases yet again to 1.0118mm at **407.** Finally, after the fourth discrete interval **408,** the diameter decreases for the last time to 0.82mm at **410.**

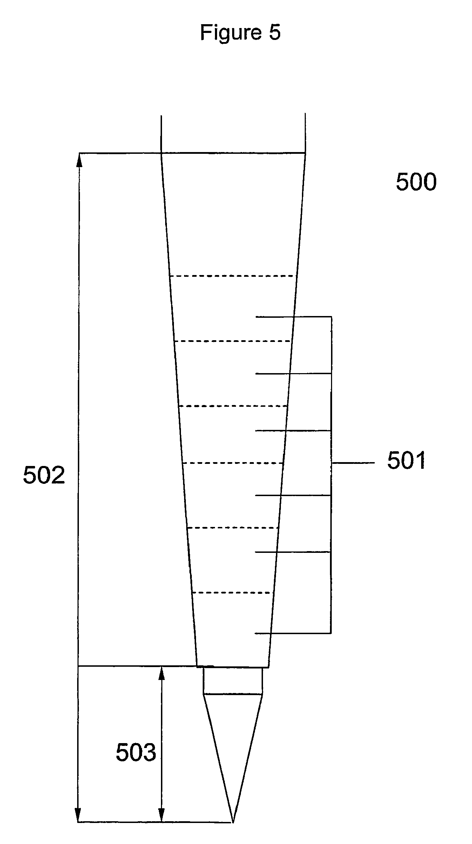

**Figure 5** shows a fourth embodiment **500** of the bonding tool according to the present invention. In this embodiment, the length of the bonding tool is denoted by **502.** The length **502** is made up of a several consecutively arranged discrete intervals **501** and a working tip portion **503.** Each of the discrete intervals **501** achieves its respective diametric decrease by way of a tapering towards the longitudinal central axis of rotation of the bonding tool. The tapering takes place in the direction of the working tip portion **503** and the tapering angle may be up to ten degrees towards the central axis.

**Figures 6A - 6F** show various embodiments of a diametric decrease over two discrete intervals. **Figure 6A** shows a step-wise reduction in diameter. The step is at a ninety degree angle to the horizontal at each discrete interval. **Figure 6B** shows the diametric decrease being carried out by two tapers at each discrete interval. The angle of the tapers may be equal of vary according to the reduction in diameter to be achieved. As mentioned previously, the tapering is in the direction of the working tip portion (not shown) and towards the central axis.

**Figure 6C** and **6D** shows the diametric reduction being achieved by a step in the form of a convex and concave arc, respectively. **Figure 6E** is an embodiment of the diametric reduction being achieved by a combination of a taper, as in **Figure 6B****,** followed by a step-wise reduction, as in **Figure 6A****.** The embodiment of **Figure 6F** achieves the diametric reduction by having a plurality of tapers. Each of the plurality of tapers is each at a different angle towards the central axis of the bonding tool.

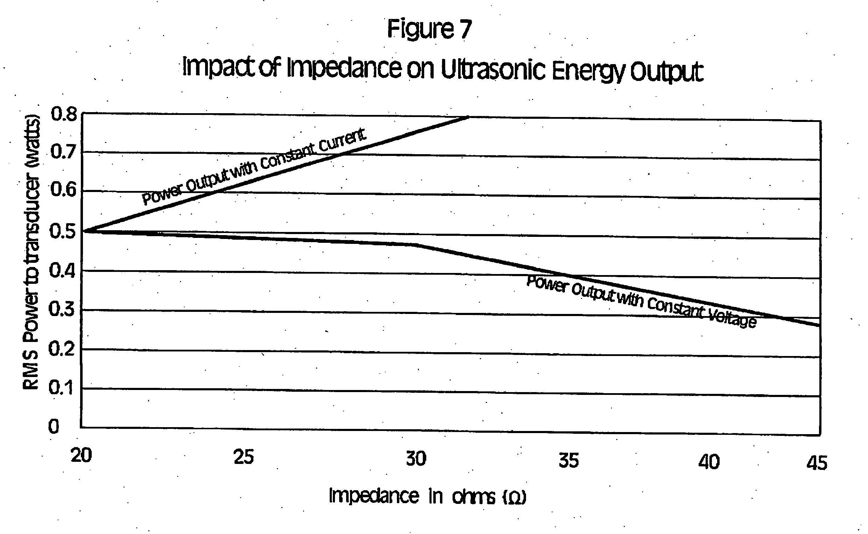

**Figure 7** shows a graph that illustrates the relationship between the input power to a transducer and the impedance generated therefrom. In a typical bonding operation, as mentioned above, the bonding tool is clamped to the ultrasonic transducer. As an initial step; a calibration via a power signal analyzer is carried out. The calibration establishes a relationship between the power supplied to the transducer to oscillate the bonding tool between predefined limits, and the impendence generated therefrom by the bonding tool. The actual impedance values are recorded via said power signal analyzer.

From the calibration step, the relationship between the power and the impedance is generally as follows:

As the power delivered (under a constant current) to the bonding tool, via the ultrasonic transducer, increases, the impedance generated, which is dependent on the type of bonding tool used, also increases correspondingly. This relationship is shown in graph of **Figure 7****.**

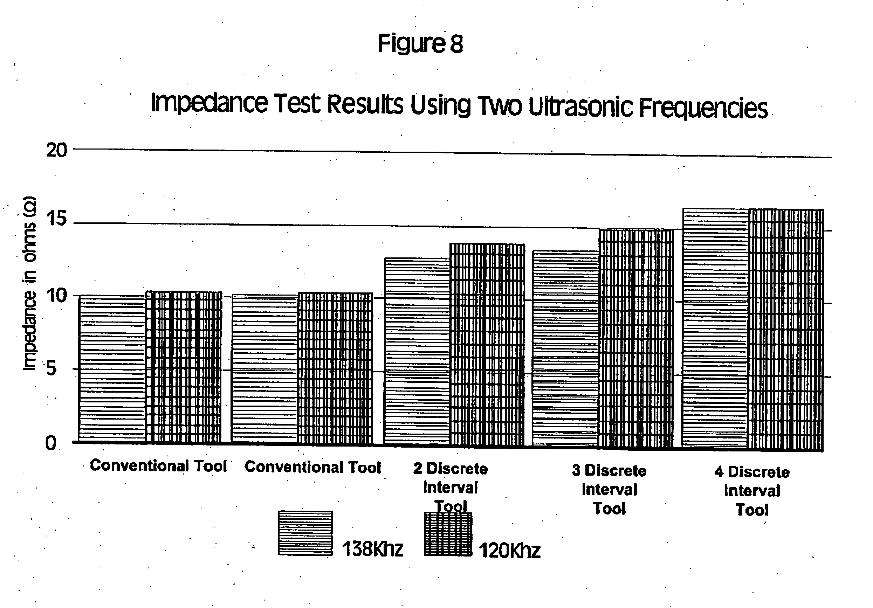

Factors that may affect the impedance generated by the bonding tool, when clamped into the ultrasonic transducer, include the design of the bonding tool. As such, each bonding tool is capable of generating different levels of impedance. This is better shown in the comparative bar chart of **Figure 8****,** which is described in detail below.

**Figure 8** shows a comparative bar chart between the impedance generated by various bonding tools. The conventional bonding tools generate slightly more than 10 ohms and about 10 ohms at ultrasonic test frequencies of 120kHz and 138kHz, respectively. In contrast, bonding tools according to the various embodiments of the present invention, which rely on the above-mentioned relationship between the output power and impedance generation, give significantly different results. These bonding tools, which have discrete intervals present over the length of said bonding tools, give rise to an increase in impedance generation at either of the test frequencies as compared to the conventional bonding tools without such discrete intervals.

Accordingly, it is shown that different (in this case, higher) impedance values may be obtained by varying the design of the bonding tool, such as, for example, by varying the diameter of said tool towards the working tip portion as in embodiments of the present invention. As such, the above-mentioned first, second, third and fourth exemplary embodiments of the present invention typically show a higher impedance value as compared to bonding tools of conventional design, i.e. those lacking discrete intervals along the length of the bonding tool.

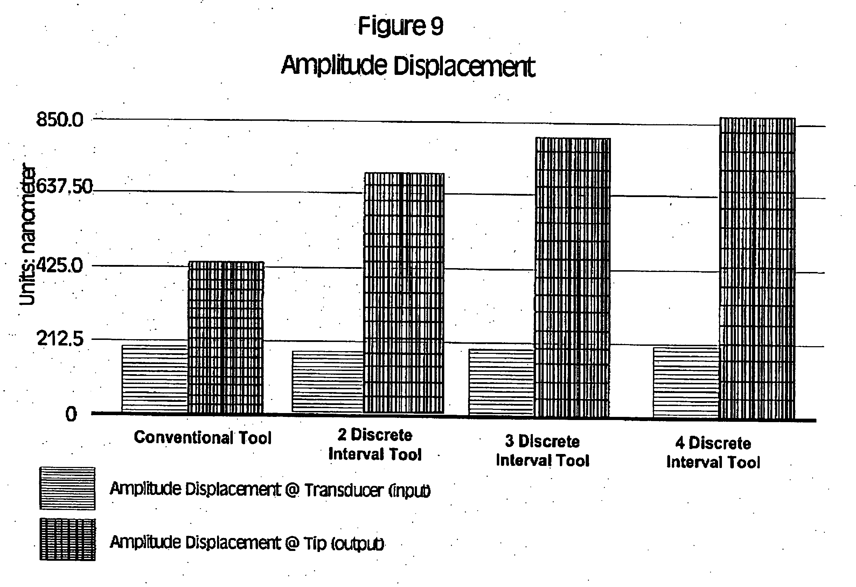

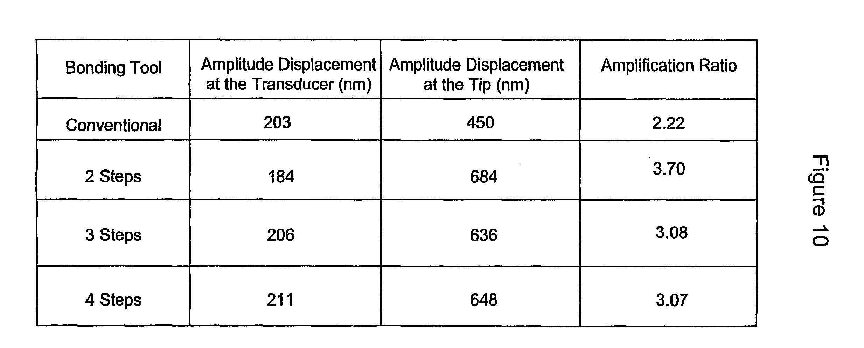

**Figure 9** shows a bar chart that compares the conventional bonding tool of **Figure 1** against the multiple discrete intervals bonding tools of the embodiments of **Figure 2****,** **3** **and** **4** and a an embodiment having four discrete intervals (not shown). A laser interferometer is used to measure the displacement of the tip. The table of **Figure 10** shows the actual values of the displacement by comparison between the aforesaid various bonding tools, which will be further discussed below. Graphically, the displacement of the tip of the bonding tools according to the present invention **(****Figures 2****,** **3****, and** **4****)** is significantly higher than that of the conventional bonding tool. It should be noted that the higher displacement of the tips is achieved while providing an input similar to that received by the conventional bonding tool.

**Figure 10** shows a table of the amplitude displacement reading of bonding tools as tested in **Figure 9****.** The table is a detailed result from the laser interferometer test done in **Figure 9** and clearly shows the amplitude displacement at the tips of the bonding tools according to the present invention **(****Figures 2****,** **3****, and** **4****)** at about a 600nm level of reading while the input from the transducer was about the 200nm range, even for the conventional bonding tool. Generally, the amplitude displacement ratio ranges between about 3.00 - 3.70 while that of the conventional tool is about 2.22.

The amplification ratio is calculated by dividing the displacement of tip by the displacement at the transducer. The amplification ratios of bonding tools according to the present invention are at least about a third greater than that of the conventional bonding tool. The combination of high amplitude displacement at the tip (≥600nm) and an amplification ratio value greater than three of the bonding tool implies that the ultrasonic power to drive the capillary may be lowered to achieve a tip displacement equivalent to that of the present conventional bonding tool. Having a lower ultrasonic input energy level aids in the formation of reliable bonds for sensitive bond pad metallization like the low-K value material, for example.

The significance of the bonding tools of the present invention having a high amplification ratio is essentially that less input energy is needed in order to achieve a tip displacement equivalent to that of conventional bonding tools. In other words, a displacement equivalent to that of conventional bonding tools may be achieved by inputting less energy than that required by the conventional bonding tool. In this connection, when bonding materials having low-K values, the utilization of less energy makes the bond pad less susceptible to metal lifting, metal peel off and cratering.

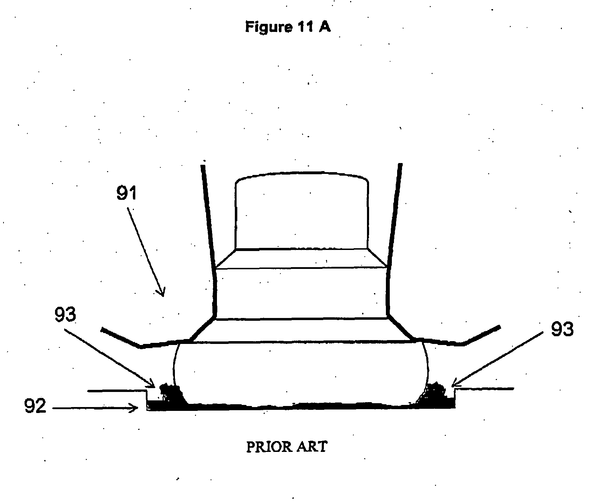

**Figure 11A** shows the cross-sectional view of a ball bond with excessive aluminum extrusion using the conventional bonding tool of **Figure 1****.** The photograph shows the cross-sectional view of the ball bonded using the conventional capillary **100.** It is observed that there is an excessive aluminum extrusion around the periphery of the ball bond in the bond pad. This causes internal voids that may result in lifted metal or metal peeling problems. The excessive aluminum extrusion of the ball bond consumes the aluminum material when subjected to baking for five hours at 175 degree Celsius, which simulates the mold curing effect on the Au-Al intermetallic layer.

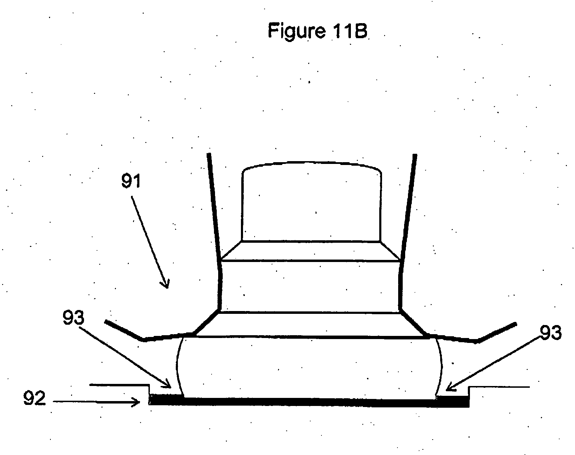

**Figure 11** **B** shows the cross-sectional view of a ball bond without excessive aluminum extrusion using the bonding tool of **Figures 2****,** **3** **and** **4****.** One advantage of the bonding tool of **Figures 2****,** **3****, and** **4** over the conventional bonding tool is shown in **Figure 11B****,** which shows the cross-sectional view of the ball-bonded unit without the excessive aluminum extrusion. The absence of excessive aluminum extrusion around the periphery of the ball bond makes the ball bond robust in terms of improved bonding adhesion reliability without bond lift-offs. Again, as above, the ball bond had undergone an exposure of five hours at 175 degree Celsius to simulate the mold-curing effect on the Au-Al intermetallic layer.

The foregoing description has been presented for purposes of illustration and description. It is not intended to be exhaustive or to limit the invention to the precise form disclosed, and obviously many modifications and variations are possible in light of the disclosed teaching. The described embodiments were chosen in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. A bonding tool (200; 300; 400; 500) for bonding a fine wire to a substrate, said bonding tool comprising:
an at least substantially cylindrical portion (202; 302; 402; 502) having a concentric capillary therein through which the fine wire runs;
a working tip portion (209; 309; 408; 503) formed at an end of the cylindrical portion being tapered towards the tip thereof, said working tip portion having an annular chamfer at the tip thereof:
wherein the concentric capillary opens into the annular chamfer of the working tip; and **characterized in that,**
the diameter of the cylindrical portion (202; 302; 402; 502) decreases consecutively at a plurality of at least two discrete intervals (206, 209; 303, 306, 309; 403; 406, 409, 408; 501) along the length of the cylindrical portion towards the working tip portion.

2. The bonding tool according to claim 1, wherein the diameter of the cylindrical portion (202) decreases consecutively at two discrete intervals (206, 209).

3. The bonding tool according to claim 1, wherein the diameter of the cylindrical portion (302; 402; 502) decreases consecutively at three, four or five discrete intervals (303, 306, 309; 403, 406, 409, 408; 501).

4. The bonding tool according to claim 1, wherein the consecutive diametric decrease at each of the plurality of discrete intervals comprises a step, a tapering, and any combination thereof towards the longitudinal central axis of rotation of the cylindrical portion (202; 302; 402; 502).

5. The bonding tool according to claim 4, wherein the step is essentially a ninety degree step, a plurality of tapers or an arc, or
wherein the tapering is angled up to 10 degrees towards the longitudinal central axis of rotation of the cylindrical portion
wherein the consecutive diametric decrease at each of the plurality of discrete intervals (206, 209; 303, 306, 309; 403, 406, 409, 408; 501) is concentric to each other.

6. The bonding tool according to claim 1, wherein the plurality of discrete intervals (206, 209; 303, 306, 309; 403, 406, 409, 408; 501) are proportionately or equally distributed over the length of the cylindrical portion (202; 302; 402; 502).

7. The bonding tool according to claim 2, wherein the first (206) and (209) second discrete intervals along the length of the cylindrical portion (202) are distant from the working tip by about 7.10mm and by about 2.65mm, respectively, or,
wherein the diameter of the cylindrical portion decreases at the first (206) and second (209) discrete intervals from about 1.587mm to about 1.20mm and from about 1.20mm to about 0.82mm, respectively.

8. The bonding tool according to claim 1, wherein the at least substantially cylindrical portion has a latitudinal cross-section that is polygonal, circular or elliptical.

9. The bonding tool according to claim 1, wherein the at least substantially cylindrical portion (202; 302; 402; 502) and working tip are adapted such as to be able to undergo an ultrasonic displacement when ultrasonic energy is transmitted to the bonding tool.

10. The bonding tool according to claim 9, wherein the working tip portion (209; 309; 408; 503) is adapted such that it has a displacement amplification ratio of at least about three when undergoing ultrasonic displacement, or
wherein the ultrasonic displacement of the at least substantially cylindrical portion (202; 302; 402; 502) and working tip is at least substantially sinusoidal.

11. The bonding tool of claim 1, wherein the length of the concentric capillary and annular chamfer is between about 9.00mm to about 20.00mm, or
wherein the concentric capillary is of a diameter between about 80µm and about 5.0mm, inclusive.

12. The bonding toot according to claim 1, wherein the concentric capillary is made from a material selected from the group consisting of a metal, a ceramic and/or a ceramic - metallic (CerMet) composite.

13. The bonding tool according to claim 12, wherein the metal is selected from the group consisting of nickel, titanium molybdenum, and cobalt,
wherein the ceramic is selected from the group consisting of oxides, carbides, nitrides and borides, and
wherein the CerMet is selected from the group consisting of cobalt bonded tungsten carbide, titanium carbonitride and titanium nitride.

14. A bonding device for forming a metallurgical bond between a fine wire and a bonding substrate, said device comprising: the bonding tool of claim 1; and
a nano-scale ultrasonic energy source connected to said bonding tool such that said source is capable of transmitting ultrasonic energy to the bonding tool.

15. The system of claim 14 wherein the bonding substrate is a bond pad or a leadframe.

## Patentansprüche

1. Ein Bondwerkzeug (200; 300; 400; 500) zum Bonden eines Feindrahtes an ein Substrat, wobei das Bondwerkzeug aufweist:
einen zumindest im Wesentlichen zylinderförmigen Abschnitt (202; 302; 402; 502), der darin eine konzentrische Kapillare aufweist, durch die der Feindraht hindurchverläuft,
einen an einem Ende des zylinderförmigen Abschnitts ausgebildeten Arbeitsspitzen-Abschnitt (209; 309; 408; 503), der in Richtung zu seiner Spitze konisch zulaufend ist, wobei der Arbeitsspitzen-Abschnitt eine ringförmige Abfasung an seiner Spitze aufweist,
wobei sich die konzentrische Kapillare in die ringförmige Abfasung der Arbeitsspitze öffnet, und
**dadurch gekennzeichnet, dass** sich der Durchmesser des zylinderförmigen Abschnitts (202; 302; 402; 502) in einer Mehrzahl von mindestens zwei diskreten Intervallen (206, 209; 303, 306, 309; 403, 406, 409, 408; 501) entlang der Länge des zylinderförmigen Abschnitts in Richtung zu dem Arbeitsspitzen-Abschnitt fortlaufend verkleinert.

2. Das Bondwerkzeug gemäß Anspruch 1, wobei sich der Durchmesser des zylinderförmigen Abschnitts (202) in zwei diskreten Intervallen (206, 209) fortlaufend verkleinert.

3. Das Bondwerkzeug gemäß Anspruch 1, wobei sich der Durchmesser des zylinderförmigen Abschnitts (302; 402; 502) in drei, vier oder fünf diskreten Intervallen (303, 306, 309; 403, 406, 409, 408; 501) fortlaufend verkleinert.

4. Das Bondwerkzeug gemäß Anspruch 1, wobei die fortlaufende verkleinerung des Durchmessers in jedem der Mehrzahl von diskreten Intervallen eine Stufe, eine Verjüngung und jede Kombination davon in Richtung zu der längsverlaufenden zentralen Drehachse des zylinderförmigen Abschnitts (202; 302; 402; 502) aufweist.

5. Das Bondwerkzeug gemäß Anspruch 4, wobei die Stufe im Wesentlichen eine Neunziggrad-Stufe, eine Mehrzahl von Verjüngungen oder ein Bogen ist, oder
wobei die Verjüngung um bis zu 10 Grad in Richtung der längsverlaufenden zentralen Drehachse des zylinderförmigen Abschnitts abgewinkelt ist, oder
wobei die fortlaufende Verkleinerung des Durchmessers in jedem der Mehrzahl von diskreten Intervallen (206, 209; 303, 306 309; 403, 406, 409, 408; 501) konzentrisch zueinander ist.

6. Das Bondwerkzeug gemäß Anspruch 1, wobei die Mehrzahl von diskreten Intervallen (206, 209; 303, 306, 309; 403, 406, 409, 408; 501) proportional oder gleich über die Länge des zylinderförmigen Abschnitts (202; 302; 402; 502) verteilt ist.

7. Das Bondwerkzeug gemäß Anspruch 2, wobei das erste (206) und das zweite (209) diskrete Intervall entlang der Länge des zylinderförmigen Abschnitts (202) um etwa 7,10 mm beziehungsweise um ungefähr 2,65 mm von der Arbeitsspitze entfernt sind, oder
wobei sich der Durchmesser des zylinderförmigen Abschnitts bei dem ersten (206) und dem zweiten (209) diskreten Intervall von ungefähr 1,587 mm auf ungefähr 1,20 mm beziehungsweise von ungefähr 1,20 mm auf ungefähr 0,82 mm verkleinert.

8. Das Bondwerkzeug gemäß Anspruch 1, wobei der zumindest im Wesentlichen zylinderförmige Abschnitt einen Breitenquerschnitt hat, der polygonal, kreisförmig oder elliptisch ist.

9. Das Bondwerkzeug gemäß Anspruch 1, wobei der zumindest im Wesentlichen zylinderförmige Abschnitt (202; 302; 402; 502) und die Arbeitsspitze angepasst sind, um in der Lage zu sein, einer Ultraschallverschiebung unterzogen zu werden, wenn Ultraschallenergie auf das Bondwerkzeug übertragen wird.

10. Das Bondwerkzeug gemäß Anspruch 9, wobei der Arbeitsspitzen-Abschnitt (209; 309; 408; 503) derart angepasst ist, dass er ein Verschiebungs-Verstärkungsverhältnis von mindestens etwa drei aufweist, wenn er einer Ultraschallverschiebung unterzogen wird, oder
wobei die Ultraschallverschiebung des zumindest im Wesentliche zylinderförmigen Abschnitts (202, 302, 402, 502) und der Arbeitsspitze zumindest im Wesentlichen sinusförmig ist.

11. Das Bondwerkzeug gemäß Anspruch 1, wobei die Länge der konzentrischen Kapillare und der ringförmigen Abfasung zwischen ungefähr 9,00 mm bis ungefähr 20,00 mm liegt oder
wobei die konzentrische Kapillare einen Durchmesser zwischen einschließlich etwa 80 µm und etwa 5,0 mm hat.

12. Das Bondwerkzeug gemäß Anspruch 1, wobei die konzentrische Kapillare aus einem Material hergestellt ist, das aus der Gruppe bestehend aus einem Metall, einer Keramik und/oder einer keramisch-metallischen (CerMet) Verbindung ausgewählt ist.

13. Das Bondwerkzeug gemäß Anspruch 12, wobei das Metall aus der Gruppe bestehend aus Nickel, Titan-Molybdän und Kobalt ausgewählt ist,
wobei die Keramik aus der Gruppe bestehend aus Oxiden, Karbiden, Nitriden und Boriden ausgewählt ist, und
wobei das CerMet aus der Gruppe bestehend aus kobaltgebundenem Wolframkarbid, Titancarbonitrid und Titannitrid ausgewählt ist.

14. Eine Bondvorrichtung zum Bilden einer metallurgischen Verbindung zwischen einem Feindraht und einem Bondsubstrat, wobei die Vorrichtung aufweist: das Bondwerkzeug aus Anspruch 1 und eine Nanobereich-Ultraschall-Energiequelle, die derart mit dem Bondwerkzeug verbunden ist, dass die Quelle in der Lage ist, Ultraschallenergie auf das Bondwerkzeug zu übertragen.

15. Das System gemäß Anspruch 14, wobei das Bondsubstrat ein Bondpad oder ein Leiterrahmen ist.

## Revendications

1. Outil de soudure (200 ; 300 ; 400 ; 500) pour souder un fil fin à un substrat, ledit outil de soudure comprenant ;
une partie au moins sensiblement cylindrique (202 ; 302 ; 402 ; 502) intégrant un tube capillaire concentrique à travers lequel est disposé le fil fin ;
une partie de pointe de travail (209 ; 309 ; 408 ; 503) formée à une extrémité de la partie cylindrique effilée en direction de la pointe de celle-ci, ladite partie de pointe de travail ayant un chanfrein annulaire à la pointe de celle-ci ;
dans lequel le tube capillaire concentrique débouche dans le chanfrein annulaire de la pointe de travail ; et
**caractérisé en ce que** le diamètre de la partie cylindrique (202 ; 302 ; 402 ; 502) diminue progressivement à une pluralité d'au moins deux intervalles discrets (206, 209 ; 303, 306, 309 ; 403, 406, 409, 408 ; 501) le long de la partie cylindrique en direction de la partie de pointe de travail.

2. Outil de soudure selon la revendication 1, dans lequel le diamètre de la partie cylindrique (202) diminue progressivement à deux intervalles discrets (206, 209).

3. Outil de soudure selon la revendication 1, dans lequel le diamètre de la partie cylindrique (302 ; 402 ; 502) diminue progressivement à trois, quatre ou cinq intervalles discrets (303, 306, 309 ; 403, 406, 409, 408 ; 501).

4. Outil de soudure selon la revendication 1, dans lequel la diminution de diamètre progressive à chacun de la pluralité d'intervalles discrets comprend une étape, une réduction, et l'une quelconque de leurs combinaisons vers l'axe de rotation central longitudinal de la partie cylindrique (202 ; 302 ; 402 ; 502).

5. Outil de soudure selon la revendication 4, dans lequel l'étape est essentiellement une étape à quatre-vingt-dix degrés, une pluralité de réductions, ou un arc, ou dans lequel la réduction est inclinée selon un angle allant jusqu'à 10 degrés vers l'axe de rotation central longitudinal de la partie cylindrique, ou dans lequel les diminutions de diamètre progressives à chacun de la pluralité d'intervalles discrets (205, 209 ; 303, 306, 309 403,406, 409, 408 ; 501) sont mutuellement concentriques.

6. Outil de soudure selon la revendication 1, dans lequel la pluralité d'intervalles discrets (206, 209 ; 303, 306, 309 ; 403, 406, 409, 408 ; 501) sont proportionnellement ou
également distribués sur la longueur de la partie cylindrique (202 ; 302 ; 402 ; 502).

7. Outil de soudure selon la revendication 2, dans lequel les premier (206) et deuxième (209) intervalles discrets le long de la longueur de la partie cylindrique (202) sont distants de la pointe de travail d'environ 7,10 mm et d'environ 2,65 mm, respectivement, ou dans lequel le diamètre de la partie cylindrique diminue aux premier (206) et deuxième (209) intervalles discrets d'environ 1,587 mm à environ 1,20 mm et d'environ 1,20 mm à environ 0,82 mm, respectivement.

8. Outil de soudure selon la revendication 1, dans lequel la partie au moins sensiblement cylindrique a une section transversale latitudinale qui est polygonale, circulaire ou elliptique.

9. Outil de soudure selon la revendication 1, dans lequel la partie au moins sensiblement cylindrique (202 ; 302 ; 402 ; 502) et la pointe de travail sont adaptées de façon à pouvoir subir un déplacement ultrasonique quand une énergie ultrasonique est transmise à l'outil de soudure.

10. Outil de soudure selon la revendication 9, dans lequel la partie de pointe de travail (209 ; 309 ; 408 ; 503) est adaptée de façon à avoir un rapport d'amplification de déplacement d'au moins environ trois lorsqu'elle subit un déplacement ultrasonique, ou dans lequel le déplacement ultrasonique de la partie au moins sensiblement cylindrique (202 ; 302 ; 402 ; 502) et de la pointe de travail est au moins sensiblement sinusoïdal.

11. Outil de soudure selon la revendication 1, dans lequel la longueur du tube capillaire concentrique et du chanfrein annulaire est comprise entre environ 9,00 mm et environ 20,00 mm, ou dans lequel le tube capillaire concentrique a un diamètre compris entre environ 80 µm et environ 5,0 mm, bornes comprises.

12. Outil de soudure selon la revendication 1, dans lequel le tube capillaire concentrique est fait en un matériau choisi dans le groupe constitué par un métal, une céramique et/ou un composite céramique-métallique (CerMet).

13. Outil de soudure selon la revendication 12, dans lequel le métal est choisi dans le groupe constitué par le nickel, le titane, le molybdène et le cobalt, dans lequel la céramique est choisie dans le groupe constitué par les oxydes, les carbures, les nitrures et les borures, et dans lequel le CerMet est choisi dans le groupe constitué par le carbure de tungstène lié à du cobalt, le carbonitrure de titane et le nitrure de titane.

14. Dispositif de soudure pour former une liaison métallurgique entre un fil fin et un substrat de liaison, ledit dispositif comprenant : l'outil de soudure de la revendication 1 ; et une source d'énergie ultrasonique nanométrique connectée audit outil de soudure de façon que ladite source soit capable de transmettre de l'énergie ultrasonique à l'outil de soudure.

15. Système selon la revendication 14, dans lequel le substrat de liaison est un plot de connexion ou une grille de connexion.
